# EUROPEAN PATENT SPECIFICATION

(11) **EP 4 407 684 B1**
(45) Date of publication and mention of the grant of the patent: **25.11.2026**
(21) Application number: 21801407.4
(22) Date of filing: 29.09.2021
(51) Int. Cl.: G02F 1/1362, G02F 1/1368, H10D 30/67, H10D 86/40, H10D 86/60

(54) **THIN FILM TRANSISTOR, DISPLAY PANEL AND PREPARATION METHOD THEREFOR**
DÜNNSCHICHTTRANSISTOR, ANZEIGETAFEL UND HERSTELLUNGSVERFAHREN DAFÜR
TRANSISTOR À COUCHES MINCES, PANNEAU D'AFFICHAGE ET SON PROCÉDÉ DE PRÉPARATION

(30) Priority: 24.09.2021 CN 202111120728
(43) Date of publication of application: 31.07.2024
(73) Proprietor: TCL CHINA STAR OPTOELECTRONICS TECHNOLOGY CO., LTD., Shenzhen, Guangdong 518132 (CN)
(72) Inventor: LU, Macai, Guangdong 518132 (CN); LIU, Minggang, Guangdong 518132 (CN); LIU, Nian, Guangdong 518132 (CN)
(74) Representative: Murgitroyd & Company
(86) International application number: PCT/CN2021/121819
(87) International publication number: WO 2023/044950

(56) References cited:
- CN-A- 111 682 033
- CN-A- 112 490 254
- CN-A- 113 345 837
- JP-A- 2021 105 638
- US-A1- 2016 181 344
- US-A1- 2017 294 464
- US-A1- 2020 096 799
- US-A1- 2020 387 019
- US-A1- 2021 183 899

## Description

### FIELD

The present disclosure relates to a field of display technologies, and more particularly, to a thin-film transistor (TFT), a display panel, and a manufacturing method of the display panel.

### BACKGROUND

In conventional back-channel etched (BCE) TFTs, to improve electrical performance, a Vgs voltage needs to be reduced as much as possible. Specifically, this can be realized by reducing a thickness of a gate insulating layer. However, reducing the thickness of the gate insulating layer not only reduces a pressure resistance between a gate and a drain but also increases capacitance between the gate and a source/drain, affecting comprehensive electrical performance of the TFTs.

JP2021105638A discloses an active matrix substrate, in-cell panel type liquid crystal display device including active matrix substrate, and manufacturing method for active matrix substrate. US2021183899A1 discloses an active matrix substrate and method for manufacturing same. US2016181344A1 discloses an organic light emitting display device and method of manufacturing the same. US2020387019A1 discloses an active matrix substrate and liquid crystal display device with touch sensor.

### SUMMARY

Embodiments of the present disclosure provide a TFT, a display panel, and a manufacturing method of the display panel to effectively improve comprehensive electrical performance of TFTs.

The present invention is defined by the independent claims as appended. Developments are set forth in the dependent claims.

An embodiment of the present disclosure provides a TFT, comprising: a gate; a gate insulating layer disposed on a side of the gate; an active layer disposed on a side of the gate insulating layer away from the gate and disposed opposite to the gate; a first electrode disposed on a side of the active layer away from the gate; and an interlayer insulating layer disposed between the first electrode and the active layer to insulate the first electrode from the active layer, a first via penetrating the interlayer insulating layer and extending to a surface of the first electrode is defined on the interlayer insulating layer, the active layer is connected to the first electrode by the first via, and a thickness of the interlayer insulating layer is greater than a thickness of the gate insulating layer; and a second electrode connected to the active layer. The second electrode and the active layer are disposed on a same layer.

Optionally, in some specific embodiments of the present disclosure, the TFT further comprises: an auxiliary electrode disposed opposite to the active layer, wherein the interlayer insulating layer is disposed between the auxiliary electrode and the active layer.

Optionally, in some specific embodiments of the present disclosure, the first electrode and the auxiliary electrode are disposed on a same layer, and the active layer is connected to the first electrode by the first via.

Optionally, in some specific embodiments of the present disclosure, the active layer comprises a semiconductor part and a first electrode contact part, conductivity of the first electrode contact part is less than conductivity of the first electrode, and the conductivity of the first electrode contact part is greater than conductivity of the semiconductor part; and the first electrode contact part is connected to the first electrode by the first via.

An embodiment of the present disclosure further provides a display panel, comprising: a first electrode disposed on a first metal layer; an interlayer insulating layer disposed on the first electrode, wherein a first via penetrating the interlayer insulating layer and extending to a surface of the first electrode is defined on the interlayer insulating layer; an active layer disposed on the interlayer insulating layer, wherein the active layer is connected to the first electrode by the first via; a second electrode connected to the active layer; a gate insulating layer disposed on the active layer; and a gate disposed on a second metal layer disposed on the gate insulating layer, wherein the gate is disposed opposite to the active layer. A thickness of the interlayer insulating layer is greater than a thickness of the gate insulating layer.

Optionally, in some specific embodiments of the present disclosure, the display panel further comprises: an auxiliary electrode disposed opposite to the active layer, wherein the interlayer insulating layer is disposed between the auxiliary electrode and the active layer. The first electrode is a drain and the second electrode is a source; and/or the first electrode is the source and the second electrode is the drain.

Optionally, in some specific embodiments of the present disclosure, the auxiliary electrode is disposed on the first metal layer, and the interlayer insulating layer covers the first electrode and the auxiliary electrode.

Optionally, in some specific embodiments of the present disclosure, the active layer comprises a semiconductor part and a first electrode contact part, conductivity of the first electrode contact part is less than conductivity of the first electrode, and the conductivity of the first electrode contact part is greater than conductivity of the semiconductor part; and the first electrode contact part is connected to the first electrode by the first via.

Optionally, in some specific embodiments of the present disclosure, the display panel further comprises a pixel electrode, wherein the pixel electrode and the active layer are disposed on a same layer, the pixel electrode is electrically connected to the active layer, and the active layer comprises a metal oxide semiconductor.

Optionally, in some specific embodiments of the present disclosure, the display panel further comprises: a substrate, wherein the first metal layer is disposed on the substrate and comprises a plurality of data lines; a plurality of scan lines disposed on the second metal layer, wherein the scan lines cross the data lines to define a plurality of sub-pixel units, and the gate, the second electrode, a thin-film transistor (TFT) composed of the first electrode, the second electrode, the first electrode, and the active layer and the pixel electrode connected to the **TFT** are disposed in the sub-pixel units; a passivation layer disposed on the second metal layer and covering the gate and the pixel electrode; and a common electrode disposed on the passivation layer and disposed opposite to the pixel electrode.

Optionally, in some specific embodiments of the present disclosure, a lateral edge of the gate, a lateral edge of the gate insulating layer, and a lateral edge of the semiconductor part of the active layer are aligned with each other.

Optionally, in some specific embodiments of the present disclosure, the thickness of the interlayer insulating layer is greater than or equal to two times the thickness of the gate insulating layer.

Optionally, in some specific embodiments of the present disclosure, the first metal layer further comprises a touch control signal line; and the display panel further comprises: a first touch control electrode, wherein the first touch control electrode and the active layer are disposed on a same layer, and the first touch control electrode is connected to the active layer; and a second touch control electrode, wherein the second touch control electrode is insulated from the first touch control electrode and is disposed opposite to the first touch control electrode.

An embodiment of the present disclosure further provides a method of manufacturing the display panel, comprising following steps:
B1, providing a substrate;
B2, forming a first metal layer on the substrate, and patterning the first metal layer to form a first electrode;
B3, disposing an interlayer insulating layer on the first metal layer, and patterning the interlayer insulating layer to form a first via;
B4, disposing a patterned active layer on the interlayer insulating layer, wherein the active layer is connected to the first electrode by the first via, and the active layer comprises a metal oxide semiconductor;
B5, forming a gate insulating layer and a second metal layer on the active layer, and a thickness of the interlayer insulating layer is greater than or equal to two times a thickness of the gate insulating layer; patterning the second metal layer to form a gate, wherein the gate and the active layer are opposite to each other; using the patterned gate as a mask plate to pattern the gate insulating layer to expose the active layer disposed on the first electrode; and using the patterned gate as the mask plate to metalize the exposed active layer to form a second electrode and a first electrode contact part which are connected to the active layer, wherein the first electrode contact part is connected to the first electrode by the first via.

Regarding the beneficial effects: in the present disclosure, a first electrode and a gate of a TFT are disposed on two sides of the active layer. By individually disposing a gate insulating layer between the gate and the active layer and an interlayer insulating layer between the first electrode and the active layer, a thickness of the gate insulating layer between the gate and the active layer and a thickness of the interlayer insulating layer between the first electrode and the active layer can be individually adjusted. Therefore, the thickness of the gate insulating layer can be reduced to reduce Vgs and the thickness of the interlayer insulating layer can be increased to improve a pressure resistance between the gate and the drain (first electrode). Moreover, increasing the thickness of the interlayer insulating layer can also reduce capacitance between the gate and the drain (first electrode), thereby significantly improving comprehensive electrical performance of the TFT.

In addition, in a manufacturing method of a display panel provided by the present disclosure, patterning of a gate insulating layer and metalization of an active layer are completed by a gate self-alignment process of a gate. Therefore, two mask plates can be saved, thereby reducing manufacturing cost.

### DESCRIPTION OF DRAWINGS

The accompanying figures to be used in the description of embodiments of the present disclosure or prior art will be described in brief to more clearly illustrate the technical solutions of the embodiments or the prior art. The accompanying figures described below are only part of the embodiments of the present disclosure, from which those skilled in the art can derive further figures without making any inventive efforts.
FIG. 1 is a cross-sectional schematic view showing a TFT according to a specific embodiment of the present disclosure.
FIG. 2 is a cross-sectional schematic view showing a display area of a display panel according to a first embodiment of the present disclosure.
FIG. 3 is a cross-sectional schematic view showing a display area of a display panel according to a second embodiment of the present disclosure.
FIGs. 4A to 4G are structural schematic views showing manufacturing processes of the display panel in FIG. 2.

### DETAILED DESCRIPTION

Hereinafter preferred embodiments of the present disclosure will be described with reference to the accompanying drawings to exemplify the embodiments of the present disclosure can be implemented, which can fully describe the technical contents of the present disclosure to make the technical content of the present disclosure clearer and easy to understand. However, the described embodiments are only some of the embodiments of the present disclosure, but not all of the embodiments. All other embodiments obtained by those skilled in the art based on the embodiments of the present disclosure without creative efforts are within the scope of the present disclosure.

The present disclosure provides a TFT, including a gate, a gate insulating layer, an active layer, an auxiliary electrode, an interlayer insulating layer, a first electrode, and a second electrode. The gate insulating layer is disposed on a side of the gate. The active layer is disposed on a side of the gate insulating layer away from the gate. The active layer is disposed opposite to the gate. The auxiliary electrode is disposed opposite to the active layer. The interlayer insulating layer is disposed between the auxiliary electrode and the active layer to insulate the auxiliary electrode from the active layer. A thickness of the interlayer insulating layer is greater than a thickness of the gate insulating layer. The first electrode and the auxiliary electrode are disposed on a same layer. A first via penetrating the interlayer insulating layer and extending to a surface of the first electrode is defined on the interlayer insulating layer. The active layer is connected to the first electrode by the first via. The second electrode is connected to the active layer. The second electrode and the active layer are disposed on a same layer.

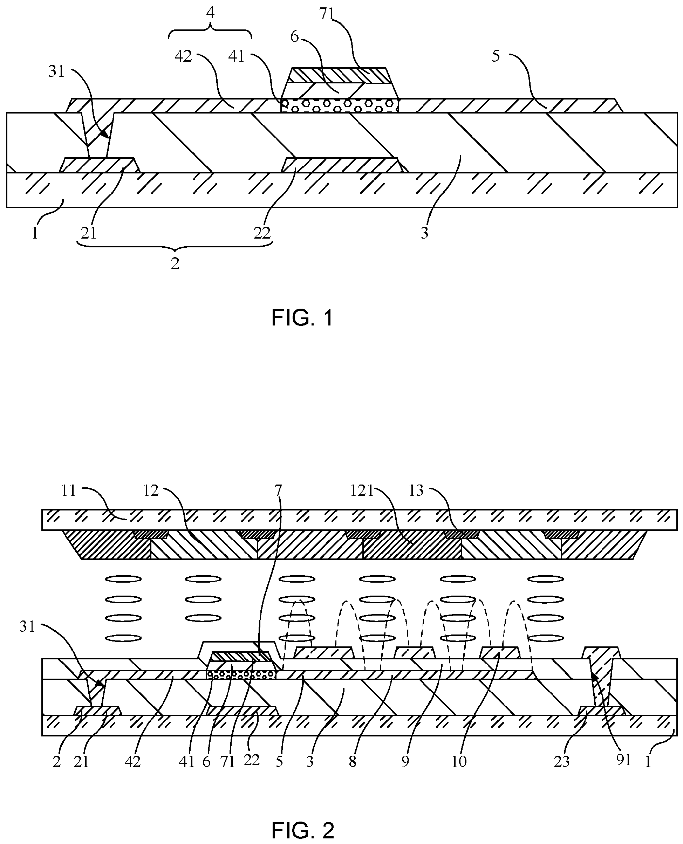

Specifically, as shown in FIG. 1, The TFT is disposed on a substrate 1.

The substrate 1 is an array substrate. The substrate 1 is a rigid substrate which can be made of glass. It should be understood that the substrate 1 may also be a flexible substrate which can be made of an organic insulating material, such as polyimide (PI) and polyethylene terephthalate (PET), that can block moisture and oxygen. No specific limitation is given here.

Afirst metal layer 2 is disposed on the substrate 1. The first metal layer 2 is patterned to form a first electrode 21 and an auxiliary electrode 22 of the TFT. The first metal layer 2 can be made of one or more of a common conductive metal, such as Mo, Al, Ti, and Cu, and an alloy. The first metal layer 2 may have a single-layer conductive layer structure made of single metal or may have a multi-layer conductive layer structure made of multiple metal. No specific limitation is given here. The first electrode 21 may be a source or a drain. In the present embodiment, the first electrode 21 is the drain connected to a data line.

The interlayer insulating layer 3 is disposed on the first metal layer 2. The interlayer insulating layer 3 covers the first electrode 21 and the auxiliary electrode 22. A first via 31 penetrating the interlayer insulating layer 3 and extending to a surface of the first electrode 21 is defined on the interlayer insulating layer 3. Commonly, the interlayer insulating layer 3 is formed by depositing or sputtering one or more of a common inorganic material, such as SiNx, SiOx, and Al₂O₃, that can block moisture and oxygen. The interlayer insulating layer 3 may also be made of an organic insulating layer to have a flat surface.

The active layer 4 is disposed on the interlayer insulating layer 3. The active layer 4 may be made of a common semiconductor material such as a metal oxide, amorphous silicon, or polycrystalline silicon. A middle area of the active layer 4 corresponds to the auxiliary electrode 22. The active layer 4 includes a semiconductor part 41 and a first electrode contact part 42. Conductivity of the first electrode contact part 42 is less than conductivity of the first electrode 21. The conductivity of the first electrode contact part 42 is greater than conductivity of the semiconductor part 41. The first electrode contact part 42 is connected to the first electrode 21 by the first via 31.

The second electrode 5 is connected to the active layer 4. The second electrode 5 is connected to the semiconductor part 41. The second electrode 5 may be the drain or the source. In the present embodiment, the second electrode 5 is the source connected to a pixel electrode or other circuits. The second electrode 5 and the active layer 4 are disposed on a same layer. The second electrode 5 and the first electrode contact part 42 are respectively disposed on two sides of the semiconductor part 41.

The gate insulating layer 6 is disposed on the active layer 4. The gate insulating layer 6 covers the semiconductor part 41. Commonly, the gate insulating layer 6 is formed by depositing or sputtering one or more of a common inorganic material such as SiNx, SiOx, and Al₂O₃. Generally, an insulating layer having a single layer can satisfy yield rate requirements of display panels. However, in display panels having an active layer made of polysilicon or a metal oxide, an insulating layer having a structure of multiple layers which are stacked may also be applied to improve a yield rate, thereby ensuring that moisture and oxygen can be effectively blocked. In the present embodiment, the gate insulating layer 6 has a structure having a single layer of SiO2 or a single layer of SiNx.

The gate 71 is disposed on the gate insulating layer 6. The gate 71 is disposed opposite to the semiconductor part 41. The gate 71 can be made of one or more of a common conductive metal, such as Mo, Al, Ti, and Cu, and an alloy. The gate 71 may have a single-layer conducive layer structure having a single metal or may have a multi-layer conductive layer structure having multiple metals. A specific limitation is not given here.

The auxiliary electrode 22 may be an auxiliary gate and/or a light-shielding electrode. The auxiliary electrode 22 is disposed opposite to the semiconductor part 41. When the auxiliary electrode 22 is the auxiliary gate, the auxiliary electrode 22 may be made of a conductive material such as metal or indium tin oxide (ITO). By disposing the auxiliary electrode 22 opposite to the semiconductor part 41, electrical performance of the TFT can be effectively improved. The auxiliary electrode 22 can be the light-shielding electrode when it is made of metal or other non-transparent materials. By disposing the auxiliary electrode 22 opposite to the semiconductor part 41, light can be prevented from being emitted on the semiconductor part 41, which affects electrical performance of the TFT.

In the TFT provided by the present embodiment, the first electrode 21 and the gate 71 are disposed on two sides of the active layer 4. The first electrode 21 is insulated from the active layer 4 by the interlayer insulating layer 3. The gate 71 is insulated from the active layer 4 by the gate insulating layer 6. An insulating layer between the gate 71 and the active layer 4 is independent from an insulating layer between the source/drain and the active layer 4. Therefore, a thickness of the insulating layer between the gate 71 and the active layer 4 and a thickness of the insulating layer between the source/drain and the active layer 4 can be individually adjusted. As such, an issue of conventional technologies can be solved: when a gate and a source/drain are disposed on a same side of an active layer, reducing a thickness of a gate insulating layer to reduce Vgs will simultaneously reduce other electrical performance of TFTs.

A thickness of the interlayer insulating layer 3 is greater than a thickness of the gate insulating layer 6. The thickness of the gate insulating layer 6 is reduced according to a predetermined target value of Vgs of the TFT. Meanwhile, the thickness of the interlayer insulating layer 3 can be unchanged or increased. Therefore, a pressure resistance between the gate 71 and the drain (first electrode 21) will not be affected when the thickness of the gate insulating layer 6 is reduced, and capacitance between the gate 71 and the drain (first electrode 21) can be increased by appropriately increasing the thickness of the interlayer insulating layer 3. Because of the above design, every electrical performance of the **TFT** can be significantly improved.

Optionally, the thickness of the interlayer insulating layer 3 is greater than or equal to two times the thickness of the gate insulating layer 6. When the thickness of the gate insulating layer 6 is one-third of the thickness of the interlayer insulating layer 3, comprehensive electrical performance of the TFT is improved.

Optionally, a lateral edge of the gate 71, a lateral edge of the gate insulating layer 6, and a lateral edge of the semiconductor part 41 of the active layer 4 are aligned with each other, thereby reducing a number of mask plates for manufacturing the TFT. Specifically, the active layer 4 includes a metal oxide semiconductor such as indium gallium zinc oxide (IGZO) or indium gallium zinc tin oxide (IGZTO). The gate insulating layer 6 is patterned with the patterned gate 71 as a plate mask to expose the active layer 4 disposed on the first electrode 21. The exposed active layer 4 is metalized with the patterned gate 71 as a plate mask to form the second electrode 5 and the first electrode contact part 42 which are connected to the active layer 4. The first electrode contact part 42 is connected to the first electrode 21 by the first via 31. Patterning of the gate insulating layer 6 and metalization of the active layer 4 are completed by a self-alignment process of the gate 71. Therefore, two mask plates are saved, thereby reducing manufacturing cost.

As shown in FIG 2, the present disclosure further provides a first embodiment of a display panel. The display panel includes a substrate 1, and a first metal layer 2, an interlayer insulating layer 3, an active layer 4, a second electrode 5, a gate insulating layer 6, a second metal layer 7, a pixel electrode 8, a passivation layer 9, and a common electrode layer 10 which are disposed on the substrate 1.

The substrate 1 is an array substrate. The substrate 1 is a rigid substrate which can be made of glass. It should be understood that the substrate 1 may also be a flexible substrate which can be made of an organic insulating material, such as PI and PET, that can block moisture. No specific limitation is given here.

A first metal layer 2 is disposed on the substrate 1. The first metal layer 2 is patterned to form a data line (not shown), and a first electrode 21, an auxiliary electrode 22, and a common electrode line 23 of the TFT. The first metal layer 2 can be made of one or more of a common conductive metal, such as Mo, Al, Ti, and Cu, and an alloy. The first metal layer 2 may have a single-layer conductive layer structure made of a single metal or may have a multi-layer conductive layer structure made of multiple metals. No specific limitation is given here. The first electrode 21 may be a source or a drain. In the present embodiment, the first electrode 21 is the drain connected to a data line.

The auxiliary electrode 22 may be an auxiliary gate and/or a light-shielding electrode. The auxiliary electrode 22 is disposed opposite to the semiconductor part 41. When the auxiliary electrode 22 is the auxiliary gate, the auxiliary electrode 22 may be made of a conductive material such as metal or ITO. By disposing the auxiliary electrode 22 opposite to the semiconductor part 41, electrical performance of the TFT can be effectively improved. The auxiliary electrode 22 can be the light-shielding electrode when it is made of metal or other non-transparent materials. By disposing the auxiliary electrode 22 opposite to the semiconductor part 41, light can be prevented from being emitted on the semiconductor part 41, and electrical performance of the TFT can be prevented from being affected.

The interlayer insulating layer 3 is disposed on the first metal layer 2. The interlayer insulating layer 3 covers the data line, the first electrode 21, the auxiliary electrode 22, and the common electrode line 23. A first via 31 penetrating the interlayer insulating layer 3 and extending to a surface of the first electrode 21 is defined on the interlayer insulating layer 3. Commonly, the interlayer insulating layer 3 is formed by depositing or sputtering one or more of a common inorganic material, such as SiNx, SiOx, and Al₂O₃, that can block moisture and oxygen. Generally, an insulating layer having a single layer can satisfy yield rate requirements of display panels. However, in display panels having an active layer made of polysilicon or a metal oxide, an insulating layer having a structure of multiple layers which are stacked may also be applied to improve a yield rate, thereby ensuring that moisture and oxygen can be effectively blocked. In the present embodiment, the insulating layer 3 has a structure having a single layer of SiO2 or a single layer of SiNx.

The active layer 4 is disposed on the interlayer insulating layer 3. The active layer 4 may be made of a common semiconductor material such as a metal oxide, an amorphous silicon, or a polycrystalline silicon. In the present embodiment, the active layer 4 is made of a metal oxide semiconductor. A middle area of the active layer 4 corresponds to the auxiliary electrode 22. The active layer 4 includes a semiconductor part 41 and a first electrode contact part 42. Conductivity of the first electrode contact part 42 is less than conductivity of the first electrode 21. The conductivity of the first electrode contact part 42 is greater than conductivity of the semiconductor part 41. The first electrode contact part 42 is connected to the first electrode 21 by the first via 31.

The second electrode 5 is connected to the active layer 4. The second electrode 5 is connected to the semiconductor part 41. The second electrode 5 may be the drain or the source. The second electrode 5 and the active layer 4 are disposed on a same layer. The second electrode 5 and the first electrode contact part 42 are respectively disposed on two sides of the semiconductor part 41.

The gate insulating layer 6 is disposed on the active layer 4. The gate insulating layer 6 covers the semiconductor part 41. Commonly, the gate insulating layer 6 is formed by depositing or sputtering one or more of a common inorganic material such as SiNx, SiOx, and Al₂O₃. Generally, an insulating layer having a single layer can satisfy yield rate requirements of display panels. However, in display panels having an active layer made of polysilicon or a metal oxide, an insulating layer having a structure of multiple layers which are stacked may also be applied to improve a yield rate, thereby ensuring that moisture and oxygen can be effectively blocked. In the present embodiment, the gate insulating layer 6 has a structure having a single layer of SiO2 or a single layer of SiNx.

The second metal layer 7 is disposed on the gate insulating layer 6. The second metal layer 7 is patterned to form a gate 71 and a scan line (not shown) of the TFT. The gate 71 is disposed opposite to the semiconductor part 41. The second metal layer 7 may be made of one or more of common conductive metal, such as Mo, Al, Ti, and Cu, and an alloy. The second metal layer 7 may have a single-layer conductive layer structure having a single metal or may be a multi-layer conductive metal structure having multiple metals. A specific limitation is not given here.

The pixel electrode 8 is disposed on the interlayer insulating layer 3. The pixel electrode 8, the active layer 4, and the second electrode 5 are disposed on a same layer. The pixel electrode 8 and the second electrode 5 are formed by performing a metal-doping process on the active layer 4. The pixel electrode 8 and the second electrode 5 are integrated. An end of the second electrode 5 is connected to the semiconductor part 41, and another end of the second electrode 5 is connected to the pixel electrode 8. The pixel electrode 8 and the second electrode 5 are formed by performing the metal-doping process on an oxide semiconductor layer. In some embodiments, the second electrode 5 can be omitted or can be regarded as a part of the pixel electrode 8, which can be determined according to the pattern of the pixel electrode 8.

The passivation layer 9 is disposed on the second metal layer 7. The passivation layer 9 covers the gate 71, the scan line, the first electrode contact part 42, the second electrode 5, and the pixel electrode 8. A second via 91 penetrating the passivation layer 9 and the interlayer insulating layer 3 and extending to a surface of a common electrode line 23 is defined on the passivation layer 9. Commonly, the passivation layer 9 is formed by depositing or sputtering one or more of a common inorganic material such as SiNx, SiOx, and Al₂O₃. Generally, an insulating layer having a single layer can satisfy yield rate requirements of display panels. However, in display panels having an active layer made of polysilicon or a metal oxide, an insulating layer having a structure of multiple layers which are stacked may also be applied to improve a yield rate, thereby ensuring that moisture and oxygen can be effectively blocked.

The common electrode 10 is disposed on the passivation layer 9. The common electrode 10 can be made of a transparent ITO material. The common electrode 10 is connected to the common electrode line 23 by the second via 91. In the present embodiment, the display panel is a fringe field switching (FFS) display panel. By stacking the planarly-disposed pixel electrode 8 and the patterned common electrode 10, a horizontal edge electrical field can be generated, thereby driving liquid crystals to be oriented. To ensure display quality, the interlayer insulating layer 3 below the pixel electrode 8 needs to be an organic insulating planarization layer. Therefore, the pixel electrode 8 can be ensured to be disposed on a same horizontal surface as possible. The common electrode 10 is disposed opposite to the pixel electrode 8, thereby generating a horizontal electrical afield to drive the liquid crystals. It should be understood that the common electrode 10 may have a star-shaped pattern, a comb-shaped pattern, or other patterns. A specific limitation is not given here.

A first alignment (not shown) is disposed on the common electrode 10 to adjust an orientation angle of the liquid crystals.

The display panel further includes a base plate 11, and a color filter layer 12, a light-shielding layer 13, and a second alignment layer (not shown) which are disposed on the substrate 11.

The base plate 11 is disposed opposite to the substrate 1. A material of the base plate 11 and a material of the substrate 1 are same an are not described here.

The color filter layer 12 includes a plurality of optical filters 121. Each sub-pixel area is provided with one optical filter 121. The optical filters 121 are disposed opposite to the pixel electrode 8.

The light-shielding layer 13 is disposed between two adjacent optical filters 121 to prevent a mixture of colors. Generally, the light-shielding layer 13 is made of a black resin material.

The second alignment layer covers the color filter layer 12 and the light-shielding layer 13 to adjust the orientation angle of the liquid crystals.

The display panel further includes a liquid crystal layer (not shown) and a barrier component (not shown) disposed between the substrate 1 and the base plate 11.

A display area of the display panel is provided with a plurality of scan lines extending along a first direction and a plurality of data lines extending along a second direction. The scan lines cross the data lines to define a plurality of sub-pixel areas arranged in an array manner. The **TFT** composed of the gate 71, the second electrode 5, the first electrode 21, and the active layer 4 and the pixel electrode 8 connected to the **TFT** are disposed in the sub-pixel units.

The auxiliary electrode 22 is disposed opposite to the semiconductor part 41. When the auxiliary electrode 22 is the auxiliary gate, the auxiliary electrode 22 may be made of a conductive material such as metal or ITO. By disposing the auxiliary electrode 22 opposite to the semiconductor part 41, electrical performance of the TFT can be effectively improved. The auxiliary electrode 22 can be the light-shielding electrode when it is made of metal or other non-transparent materials. By disposing the auxiliary electrode 22 opposite to the semiconductor part 41, light can be prevented from being emitted on the semiconductor part 41, and electrical performance of the TFT can be prevented from being affected.

In the display panel provided by the present embodiment, the first electrode 21 and the gate 71 of the TFT are disposed on two sides of the active layer 4. The first electrode 21 is insulated from the active layer 4 by the interlayer insulating layer 3. The gate 71 is insulated from the active layer 4 by the gate insulating layer 6. An insulating layer between the gate 71 and the active layer 4 is independent from an insulating layer between the source/drain and the active layer 4. Therefore, a thickness of the insulating layer between the gate 71 and the active layer 4 and a thickness of the insulating layer between the source/drain and the active layer 4 can be individually adjusted. As such, an issue of conventional technologies can be solved: when a gate and a source/drain are disposed on a same side of an active layer, reducing a thickness of a gate insulating layer to reduce Vgs will simultaneously reduce other electrical performance of TFTs.

A thickness of the interlayer insulating layer 3 is greater than a thickness of the gate insulating layer 6. The thickness of the gate insulating layer 6 is reduced according to a predetermined target value of Vgs of the TFT. Meanwhile, the thickness of the interlayer insulating layer 3 can be unchanged or increased. Therefore, a pressure resistance between the gate 71 and the drain (first electrode 21) will not be affected when the thickness of the gate insulating layer 6 is reduced, and capacitance between the gate 71 and the drain (first electrode 21) can be increased by appropriately increasing the thickness of the interlayer insulating layer 3. Because of the above design, every electrical performance of the **TFT** can be significantly improved.

Optionally, the thickness of the interlayer insulating layer 3 is greater than or equal to two times the thickness of the gate insulating layer 6. When the thickness of the gate insulating layer 6 is one-third of the thickness of the interlayer insulating layer 3, comprehensive electrical performance of the TFT is improved.

Optionally, a lateral edge of the gate 71, a lateral edge of the gate insulating layer 6, and a lateral edge of the semiconductor part 41 of the active layer 4 are aligned with each other, thereby reducing a number of mask plates for manufacturing the TFT. Specifically, the active layer 4 includes a metal oxide semiconductor such as IGZO or IGZTO. The gate insulating layer 6 is patterned with the patterned gate 71 as a plate mask to expose the active layer 4 disposed on the first electrode 21. The exposed active layer 4 is metalized with the patterned gate 71 as a plate mask to form the second electrode 5 and the first electrode contact part 42 which are connected to the active layer 4. The first electrode contact part 42 is connected to the first electrode 21 by the first via 31. Patterning of the gate insulating layer 6 and metalization of the active layer 4 are completed by a self-alignment process of the gate 71. Therefore, two mask plates are saved, thereby reducing manufacturing cost.

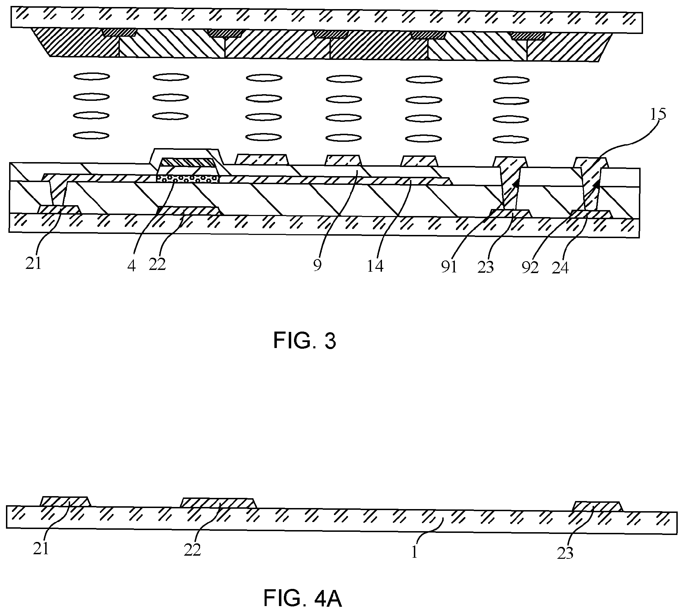

As shown in FIG. 3, the present embodiment further provides a second embodiment of a display panel. Differences between the present embodiment and the first embodiment include:
The first metal layer 2 further includes a touch control signal line. The first metal layer 2 is patterned to form the first electrode 21, the auxiliary electrode 22, the common electrode line 23, and a touch control signal line 24.

A third via 92, which penetrates the passivation layer 9 and the interlayer insulating layer 3, extends to the second via 91 on the surface of the common electrode line 23, and extends to a surface of the touch control signal line 24, is defined on the passivation layer 9.

When the display panel has a mutual-capacitive touch control structure, the display panel further includes a first touch control electrode 14 and a second touch control electrode 15. According to the invention, the first touch control electrode 14 and the active layer 4 are disposed on a same layer. The touch control electrode 14 is connected to the active layer 4. The second touch control electrode 15 is insulated from the first touch control electrode 14 and is disposed opposite to the first touch control electrode 14. The second touch control electrode 15 and the common electrode 10 are disposed on a same layer. The second touch control electrode 15 is connected to the touch control signal line 24 by the third via 92.

When the display panel has a self-capacitive touch control structure, the display panel only includes a layer of the second touch control electrode 15 disposed on a same layer as the common electrode. The second touch control electrode 15 is connected to the touch control signal line 24 by the third via 92.

Other structures of the present embodiment are same as the structures of the first embodiment and are not described again here.

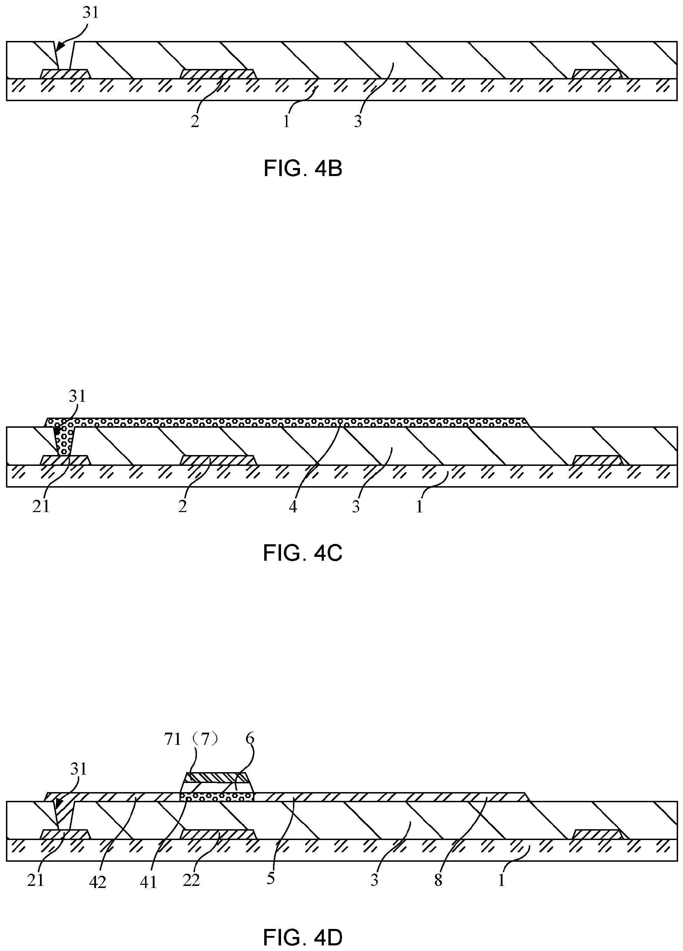

As shown in FIGs. 4A to 4G, the present disclosure further provides a specific embodiment of a method of manufacturing a display panel, including following steps:
B1, providing a substrate 1.
B2, as shown in FIG. 4A, forming a first metal layer 2 on the substrate 1, and patterning the first metal layer 2 to form a first electrode 21.
   Optionally, the step B2 includes forming the first metal layer 2 on the substrate 1, and patterning the first metal layer 2 to form the first electrode 21, an auxiliary electrode layer 2, a common electrode line 23, and a data line (not shown).
B3, as shown in FIG. 4B, disposing an interlayer insulating layer 3 on the first metal layer 2, and patterning the interlayer insulating layer 3 to form a first via 31. The first via 31 penetrates the interlayer insulating layer 3 and extends to a surface of the first electrode 21.
B4, as shown in FIG. 4C, disposing a patterned active layer 4 on the interlayer insulating layer 3. The active layer 4 is connected to the first electrode 21 by the first via 31. The active layer 4 is an oxide semiconductor layer.
B5, as shown in FIG. 4D, forming a gate insulating layer 6 and a second metal layer 7 on the active layer 4, wherein a thickness of the interlayer insulating layer 3 is greater than or equal to two times a thickness of the gate insulating layer 6, and patterning the second metal layer 7 to form a gate 71 and a scan line (not shown), wherein the gate 71 is disposed opposite to the active layer 4. Optionally, the gate 71 is disposed opposite to the auxiliary electrode 22.

Patterning the gate insulating layer 6 with the patterned gate 71 as a mask plate to expose the active layer 4 disposed on the first electrode 21, aligning a lateral edge of the gate 71 with a lateral edge of the gate insulating layer 6. Using the gate 71 as a mask plate to pattern the gate insulating layer 6 can save one mask plate.

Performing a metal-doping process on the exposed active layer 4 with the patterned gate 71 as a mask plate to form a pixel electrode 8, and a second electrode 5 and the first electrode contact part 42 which are connected to a semiconductor part 41, and aligning the lateral edge of the gate 71, the lateral edge of the gate insulating layer 6, and a lateral edge of the semiconductor part 41 with each other. The first electrode contact part 42 is connected to the first electrode 21 by the first via 31.

The second electrode 5 is connected to the active layer 4. The second electrode 5 is connected to the semiconductor part 41. The second electrode 5 is a drain or a source. The second electrode 5 and the semiconductor part 41 are disposed on a same layer. The second electrode 5 and the first electrode contact part 42 are respectively disposed on two sides of the semiconductor part 41.

The second electrode 5 and the pixel electrode 8 have a same material. A pattern of the pixel electrode 8 is planar. The second electrode 5 and the pixel electrode 8 are integrated. The pixel electrode 8 and the second electrode 5 are formed by performing a metal-doping process on an oxide semiconductor layer. In some embodiments, the second electrode 5 can be omitted or can be regarded as a part of the pixel electrode 8, which can be determined according to the pattern of the pixel electrode 8.

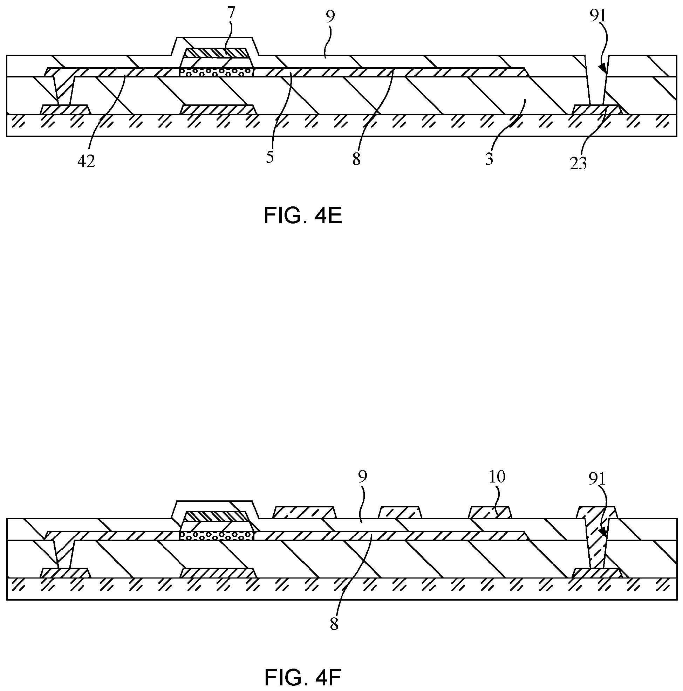

B6, as shown in FIG. 4E, forming a passivation layer 9 on the second metal layer 7, wherein the passivation layer 9 covers the gate 71, the scan line, the first electrode contact part 42, the second electrode 5, and the pixel electrode 8, and patterning the passivation layer 9 to define a second via 91 penetrating the passivation layer 9 and the interlayer insulating layer 3 and extending to a surface of a common electrode line 23.

B7, as shown in FIG. 4F, forming a common electrode layer on the passivation layer 9, and patterning the common electrode layer to form a common electrode 10. The common electrode 10 can be made of a transparent ITO material. The common electrode 10 is comb-shaped. By stacking the planarly-disposed pixel electrode 8 and the patterned common electrode 10, a horizontal edge electrical field can be generated, thereby driving liquid crystals to be oriented. The common electrode 10 is connected to the common electrode line 23 by the second via 91.

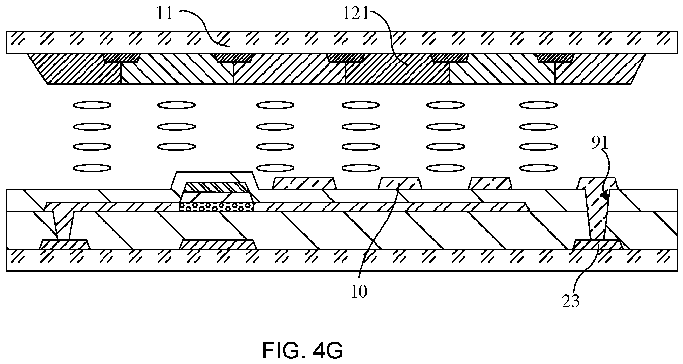

B8, as shown in FIG. 4G, covering a color filter substrate on the common electrode 10, and sealing the liquid crystals between the color filter substrate and an optical filter 121.

In the display panel provided by the present embodiment, the first electrode 21 and the gate 71 of the TFT are disposed on two sides of the active layer 4. The gate insulating layer 6 between the gate 71 and the active layer 4 is independent from the interlayer insulating layer 6 between the first electrode 21 and the active layer 4. Therefore, a thickness of the gate insulating layer 6 between the gate 71 and the active layer 4 and a thickness of the interlayer insulating layer 6 between the first electrode 21 and the active layer 4 can be individually adjusted. Therefore, the thickness of the gate insulating layer 6 can be reduced to reduce Vgs and the thickness of the interlayer insulating layer 3 can be increased to improve a pressure resistance between the gate 7 and the drain (first electrode 21). Moreover, increasing the thickness of the interlayer insulating layer 3 can also reduce capacitance between the gate 7 and the drain (first electrode 21), thereby significantly improving comprehensive electrical performance of the TFT.

In addition, in a manufacturing method of a display panel provided by the present disclosure, patterning of the gate insulating layer 6 and metalization of an active layer 4 are completed by a gate self-alignment process of the gate 71. Therefore, two mask plates can be saved, thereby reducing manufacturing cost.

A TFT, a display panel, and a manufacturing method of the display panel have been described in detail by the above embodiments, which illustrate principles and implementations thereof. However, the description of the above embodiments is only for helping to understand the technical solution of the present disclosure and core ideas thereof, and it is understood by those skilled in the art that many changes and modifications to the described embodiments can be carried out without departing from the scope of the disclosure that is intended to be limited only by the appended claims.

## Claims

1. A display panel, comprising:
a first electrode (21) disposed on a first metal layer (2);
an interlayer insulating layer (3) disposed on the first electrode (21), wherein a first via (31) penetrating the interlayer insulating layer (3) and extending to a surface of the first electrode (21) is defined on the interlayer insulating layer (3);
an active layer (4) disposed on the interlayer insulating layer (3), wherein the active layer (4) is connected to the first electrode (21) by the first via (31);
a second electrode (5) connected to the active layer (4);
a gate insulating layer (6) disposed on the active layer (4); and
a gate (71) disposed on a second metal layer (7) disposed on the gate insulating layer (6), wherein the gate (71) is disposed opposite to the active layer (4);
wherein a thickness of the interlayer insulating layer (3) is greater than a thickness of the gate insulating layer (6);
**characterized in that** the first metal layer (2) comprises a touch control signal line (24); and the display panel comprises:
a first touch control electrode (14), wherein the first touch control electrode (14) and the active layer (4) are disposed on a same layer, and the first touch control electrode (14) is connected to the active layer (4).

2. The display panel of claim 1, comprising:
an auxiliary electrode (22) disposed opposite to the active layer (4), wherein the interlayer insulating layer (3) is disposed between the auxiliary electrode (22) and the active layer (4).

3. The display panel of claim 1, **characterized in that** the first electrode (21) is a drain and the second electrode (5) is a source; or
the first electrode (21) is the source and the second electrode (5) is the drain; and
the auxiliary electrode (22) is disposed on the first metal layer (2), and the interlayer insulating layer (3) covers the first electrode (21) and the auxiliary electrode (22).

4. The display panel of claim 1, **characterized in that** the active layer (4) comprises a semiconductor part (41) and a first electrode contact part (42), conductivity of the first electrode contact part (42) is less than conductivity of the first electrode (21), and the conductivity of the first electrode contact part (42) is greater than conductivity of the semiconductor part (41); and
the first electrode contact part (42) is connected to the first electrode (21) by the first via (31).

5. The display panel of claim 1, **characterized in that** the display panel comprises a pixel electrode (8), wherein the pixel electrode (8) and the active layer (4) are disposed on a same layer, the pixel electrode (8) is electrically connected to the active layer (4), and the active layer (4) comprises a metal oxide semiconductor.

6. The display panel of claim 5, **characterized in that** the display panel comprises:
a substrate (1), wherein the first metal layer (2) is disposed on the substrate (1) and comprises a plurality of data lines;
a plurality of scan lines disposed on the second metal layer (7), wherein the scan lines cross the data lines to define a plurality of sub-pixel units, and the gate (71), the second electrode (5), a thin-film transistor (TFT) composed of the first electrode (21), the second electrode (5), the first electrode (21), and the active layer (4) and the pixel electrode (8) connected to the **TFT** are disposed in the sub-pixel units;
a passivation layer (9) disposed on the second metal layer (7) and covering the gate (71) and the pixel electrode (8); and
a common electrode (10) disposed on the passivation layer (9) and disposed opposite to the pixel electrode (8).

7. The display panel of claim 1, **characterized in that** a lateral edge of the gate (71), a lateral edge of the gate insulating layer (6), and a lateral edge of the semiconductor part (41) of the active layer (4) are aligned with each other.

8. The display panel of claim 1, **characterized in that** the thickness of the interlayer insulating layer (3) is greater than or equal to two times the thickness of the gate insulating layer (6); or
the thickness of the interlayer insulating layer (3) is equal to three times the thickness of the gate insulating layer (6).

9. The display panel of claim 1, **characterized in that** the display panel comprises a second touch control electrode (15), wherein the second touch control electrode (15) is insulated from the first touch control electrode (14) and is disposed opposite to the first touch control electrode (14).

10. A method of manufacturing the display panel,
**characterized in that** the method comprises following steps:
B1, providing a substrate (1);
B2, forming a first metal layer (2) on the substrate (1), and patterning the first metal layer (2) to form a first electrode (21) and a touch control signal line (24);
B3, disposing an interlayer insulating layer (3) on the first metal layer (2), and patterning the interlayer insulating layer (3) to form a first via (31);
B4, disposing a patterned active layer (4) on the interlayer insulating layer (3), wherein the active layer (4) is connected to the first electrode (21) by the first via (31), and the active layer (4) comprises a metal oxide semiconductor;
B5, forming a gate insulating layer (6) and a second metal layer (7) on the active layer (4), and a thickness of the interlayer insulating layer (3) is greater than or equal to two times a thickness of the gate insulating layer (6);
patterning the second metal layer (7) to form a gate (71), wherein the gate (71) and the active layer (4) are disposed opposite to each other;
using the patterned gate (71) as a mask plate to pattern the gate insulating layer (6) to expose the active layer (4) disposed on the first electrode (21); and
using the patterned gate (71) as the mask plate to metalize the exposed active layer (4) to form a second electrode (5), a first electrode contact part (42) and a first touch control electrode (14) which are connected to the active layer (4), wherein the first electrode contact part (42) is connected to the first electrode (21) by the first via (31).

## Patentansprüche

1. Ein Anzeigefeld, umfassend:
eine erste Elektrode (21), die auf einer ersten Metallschicht (2) angeordnet ist;
eine auf der ersten Elektrode (21) angeordnete Zwischenschicht-Isolierschicht (3), wobei auf der Zwischenschicht-Isolierschicht (3) eine erste Durchkontaktierung (31) ausgebildet ist, die die Zwischenschicht-Isolierschicht (3) durchdringt und sich bis zu einer Oberfläche der ersten Elektrode (21) erstreckt;
eine auf der Zwischenschicht-Isolierschicht (3) angeordnete aktive Schicht (4), wobei die aktive Schicht (4) über die erste Durchkontaktierung (31) mit der ersten Elektrode (21) verbunden ist;
eine zweite Elektrode (5), die mit der aktiven Schicht (4) verbunden ist;
eine auf der aktiven Schicht (4) angeordnete Gate-Isolierschicht (6); und
ein Gate (71), das auf einer zweiten Metallschicht (7) angeordnet ist, die wiederum auf der Gate-Isolierschicht (6) liegt, wobei das Gate (71) der aktiven Schicht (4) gegenüberliegt;
wobei die Dicke der Zwischenschicht-Isolierschicht (3) größer ist als die Dicke der Gate-Isolierschicht (6);
**dadurch gekennzeichnet, dass** die erste Metallschicht (2) eine Berührungssteuerungs-Signalleitung (24) umfasst; und dass das Anzeigefeld umfasst:
eine erste Berührungssteuerelektrode (14), wobei die erste Berührungssteuerelektrode (14) und die aktive Schicht (4) auf derselben Schicht angeordnet sind und die erste Berührungssteuerelektrode (14) mit der aktiven Schicht (4) verbunden ist.

2. Anzeigefeld nach Anspruch 1, umfassend:
eine gegenüber der aktiven Schicht (4) angeordnete Hilfselektrode (22), wobei die Zwischenschicht-Isolierschicht (3) zwischen der Hilfselektrode (22) und der aktiven Schicht (4) angeordnet ist.

3. Anzeigefeld nach Anspruch 1, **dadurch gekennzeichnet, dass** die erste Elektrode (21) ein Drain und die zweite Elektrode (5) eine Source ist; oder
die erste Elektrode (21) die Source und die zweite Elektrode (5) der Drain ist; und
die Hilfselektrode (22) auf der ersten Metallschicht (2) angeordnet ist, und die Zwischenschicht-Isolierschicht (3) die erste Elektrode (21) und die Hilfselektrode (22) bedeckt.

4. Anzeigefeld nach Anspruch 1, **dadurch gekennzeichnet, dass** die aktive Schicht (4) einen Halbleiterabschnitt (41) und einen ersten Elektrodenkontaktabschnitt (42) umfasst, wobei die Leitfähigkeit des ersten Elektrodenkontaktabschnitts (42) geringer ist als die Leitfähigkeit der ersten Elektrode (21) und die Leitfähigkeit des ersten Elektrodenkontaktabschnitts (42) größer ist als die Leitfähigkeit des Halbleiterabschnitts (41); und
der erste Elektrodenkontaktabschnitt (42) über die erste Durchkontaktierung (31) mit der ersten Elektrode (21) verbunden ist.

5. Anzeigefeld nach Anspruch 1, **dadurch gekennzeichnet, dass** das Anzeigefeld eine Pixelelektrode (8) umfasst, wobei die Pixelelektrode (8) und die aktive Schicht (4) auf derselben Schicht angeordnet sind, die Pixelelektrode (8) elektrisch mit der aktiven Schicht (4) verbunden ist und die aktive Schicht (4) einen Metalloxid-Halbleiter umfasst.

6. Anzeigefeld nach Anspruch 5, **dadurch gekennzeichnet, dass** das Anzeigefeld umfasst:
ein Substrat (1), wobei die erste Metallschicht (2) auf dem Substrat (1) angeordnet ist und eine Vielzahl von Datenleitungen umfasst;
eine Vielzahl von Abtastleitungen, die auf der zweiten Metallschicht (7) angeordneten sind, wobei die Abtastleitungen die Datenleitungen kreuzen, um eine Vielzahl von Subpixel-Einheiten zu definieren, und das Gate (71), die zweite Elektrode (5), ein Dünnschichttransistor (TFT), bestehend aus der ersten Elektrode (21), der zweiten Elektrode (5), dem Gate (71) sowie der aktiven Schicht (4), und die mit dem TFT verbundene Pixelelektrode (8) in den Subpixel-Einheiten angeordnet sind;
eine Passivierungsschicht (9), die auf der zweiten Metallschicht (7) angeordnet ist und das Gate (71) sowie die Pixelelektrode (8) bedeckt; und
eine gemeinsame Elektrode (10), die auf der Passivierungsschicht (9) angeordnet ist und der Pixelelektrode (8) gegenüberliegt.

7. Anzeigefeld nach Anspruch 1, **dadurch gekennzeichnet, dass** eine Seitenkante des Gates (71), eine Seitenkante der Gate-Isolierschicht (6) und eine Seitenkante des Halbleiterabschnitts (41) der aktiven Schicht (4) miteinander fluchten.

8. Anzeigefeld nach Anspruch 1, **dadurch gekennzeichnet, dass** die Dicke der Zwischenschicht-Isolierschicht (3) größer oder gleich dem Zweifachen der Dicke der Gate-Isolierschicht (6) ist; oder
die Dicke der Zwischenschicht-Isolierschicht (3) entspricht dem Dreifachen der Dicke der Gate-Isolierschicht (6).

9. Anzeigefeld nach Anspruch 1, **dadurch gekennzeichnet, dass** das Anzeigefeld eine zweite Berührungssteuerelektrode (15) umfasst, wobei die zweite Berührungssteuerelektrode (15) von der ersten Berührungssteuerelektrode (14) isoliert ist und der ersten Berührungssteuerelektrode (14) gegenüberliegend angeordnet ist.

10. Verfahren zur Herstellung des Anzeigefelds, **dadurch gekennzeichnet, dass** das Verfahren die folgenden Schritte umfasst:
B1, Bereitstellen eines Substrats (1);
B2, Bilden einer ersten Metallschicht (2) auf dem Substrat (1) und Strukturieren der ersten Metallschicht (2), um eine erste Elektrode (21) und eine Berührungssteuerungs-Signalleitung (24) zu bilden;
B3, Anordnen einer Zwischenschicht-Isolierschicht (3) auf der ersten Metallschicht (2) und Strukturieren der Zwischenschicht-Isolierschicht (3), um eine erste Durchkontaktierung (31) zu bilden;
B4, Anordnen einer strukturierten aktiven Schicht (4) auf der Zwischenschicht-Isolierschicht (3), wobei die aktive Schicht (4) über die erste Durchkontaktierung (31) mit der ersten Elektrode (21) verbunden ist und die aktive Schicht (4) einen Metalloxid-Halbleiter umfasst;
B5, Bilden einer Gate-Isolierschicht (6) und einer zweiten Metallschicht (7) auf der aktiven Schicht (4), wobei die Dicke der Zwischenschicht-Isolierschicht (3) größer oder gleich zweimal der Dicke der Gate-Isolierschicht (6) ist;
Strukturieren der zweiten Metallschicht (7), um ein Gate (71) zu bilden, wobei das Gate (71) und die aktive Schicht (4) einander gegenüberliegend angeordnet sind;
Verwenden des strukturierten Gates (71) als Maskenplatte, um die Gate-Isolierschicht (6) zu strukturieren und so die auf der ersten Elektrode (21) angeordnete aktive Schicht (4) freizulegen; und
Verwenden des strukturierten Gates (71) als Maskenplatte, um die freiliegende aktive Schicht (4) zu metallisieren und so eine zweite Elektrode (5), einen ersten Elektrodenkontaktabschnitt (42) und eine erste Berührungssteuerelektrode (14) zu bilden, die mit der aktiven Schicht (4) verbunden sind, wobei der erste Elektrodenkontaktabschnitt (42) über die erste Durchkontaktierung (31) mit der ersten Elektrode (21) verbunden ist.

## Revendications

1. Panneau d'affichage, comprenant :
une première électrode (21) disposée sur une première couche métallique (2) ;
une couche isolante intercouche (3) disposée sur la première électrode (21), dans laquelle un premier trou de connexion (31), traversant la couche isolante intercouche (3) et s'étendant jusqu'à une surface de la première électrode (21), est défini sur la couche isolante intercouche (3) ;
une couche active (4) disposée sur la couche isolante intercouche (3), la couche active (4) étant reliée à la première électrode (21) par le premier trou de connexion (31) ;
une deuxième électrode (5) reliée à la couche active (4) ;
une couche isolante de grille (6) disposée sur la couche active (4) ; et
une grille (71) disposée sur une deuxième couche métallique (7) située sur la couche isolante de grille (6), la grille (71) étant disposée en face de la couche active (4) ;
dans lequel l'épaisseur de la couche isolante intercouche (3) est supérieure à celle de la couche isolante de grille (6) ;
**caractérisé en ce que** la première couche métallique (2) comprend une ligne de signal de commande tactile (24) ; et le panneau d'affichage comprend :
une première électrode de commande tactile (14), la première électrode de commande tactile (14) et la couche active (4) étant disposées sur une même couche, et la première électrode de commande tactile (14) étant reliée à la couche active (4).

2. Panneau d'affichage selon la revendication 1, comprenant :
une électrode auxiliaire (22) disposée en face de la couche active (4), la couche isolante intercouche (3) étant intercalée entre l'électrode auxiliaire (22) et la couche active (4).

3. Panneau d'affichage selon la revendication 1, **caractérisé en ce que** la première électrode (21) est un drain et la deuxième électrode (5) est une source ; ou
la première électrode (21) est la source et la deuxième électrode (5) est le drain ; et
l'électrode auxiliaire (22) est disposée sur la première couche métallique (2), et la couche isolante intercouche (3) recouvre la première électrode (21) et l'électrode auxiliaire (22).

4. Panneau d'affichage selon la revendication 1, **caractérisé en ce que** la couche active (4) comprend une partie semi-conductrice (41) et une première partie de contact d'électrode (42), la conductivité de la première partie de contact d'électrode (42) est inférieure à celle de la première électrode (21), et la conductivité de la première partie de contact d'électrode (42) est supérieure à celle de la partie semi-conductrice (41) ; et
la première partie de contact d'électrode (42) est reliée à la première électrode (21) par le premier trou de connexion (31).

5. Panneau d'affichage selon la revendication 1, **caractérisé en ce que** le panneau d'affichage comprend une électrode de pixel (8), l'électrode de pixel (8) et la couche active (4) étant disposées sur une même couche, l'électrode de pixel (8) étant reliée électriquement à la couche active (4), et la couche active (4) comprenant un semi-conducteur à oxyde métallique.

6. Panneau d'affichage selon la revendication 5, **caractérisé en ce que** le panneau d'affichage comprend :
un substrat (1), dans lequel la première couche métallique (2) est disposée sur le substrat (1) et comprend une pluralité de lignes de données ;
une pluralité de lignes de balayage disposées sur la deuxième couche métallique (7), les lignes de balayage croisant les lignes de données pour définir une pluralité d'unités de sous-pixels, et la grille (71), la deuxième électrode (5), un transistor à couche mince (TFT) composé de la première électrode (21), de la deuxième électrode (5), de la grille (71) et de la couche active (4), ainsi que l'électrode de pixel (8) reliée au TFT, sont disposés dans les unités de sous-pixels ;
une couche de passivation (9) disposée sur la deuxième couche métallique (7) et recouvrant la grille (71) et l'électrode de pixel (8) ; et
une électrode commune (10) disposée sur la couche de passivation (9) et située en face de l'électrode de pixel (8).

7. Panneau d'affichage selon la revendication 1, **caractérisé en ce qu'**un bord latéral de la grille (71), un bord latéral de la couche isolante de grille (6) et un bord latéral de la partie semi-conductrice (41) de la couche active (4) sont alignés les uns par rapport aux autres.

8. Panneau d'affichage selon la revendication 1, **caractérisé en ce que** l'épaisseur de la couche isolante intercouche (3) est supérieure ou égale à deux fois l'épaisseur de la couche isolante de grille (6) ; ou
l'épaisseur de la couche isolante intercouche (3) est égale à trois fois l'épaisseur de la couche isolante de grille (6).

9. Panneau d'affichage selon la revendication 1, **caractérisé en ce que** le panneau d'affichage comprend une deuxième électrode de commande tactile (15), ladite deuxième électrode de commande tactile (15) étant isolée de la première électrode de commande tactile (14) et disposée en face de celle-ci.

10. Procédé de fabrication du panneau d'affichage, **caractérisé en ce qu'**il comprend les étapes suivantes :
B1, consistant à fournir un substrat (1) ;
B2, consistant à former une première couche métallique (2) sur le substrat (1), puis à structurer cette première couche métallique (2) afin de former une première électrode (21) et une ligne de signal de commande tactile (24) ;
B3, déposer une couche isolante intercouche (3) sur la première couche métallique (2), puis structurer la couche isolante intercouche (3) afin de former un premier trou de connexion (31) ;
B4, déposer une couche active structurée (4) sur la couche isolante intercouche (3), la couche active (4) étant reliée à la première électrode (21) par le premier trou de connexion (31), et la couche active (4) comprenant un semi-conducteur à oxyde métallique ;
B5, consistant à former une couche isolante de grille (6) et une deuxième couche métallique (7) sur la couche active (4), et l'épaisseur de la couche isolante intercouche (3) étant supérieure ou égale à deux fois l'épaisseur de la couche isolante de grille (6) ;
structurer la deuxième couche métallique (7) pour former une grille (71), la grille (71) et la couche active (4) étant disposées en vis-à-vis l'une de l'autre ;
en utilisant la grille structurée (71) comme plaque de masquage pour structurer la couche isolante de grille (6) afin d'exposer la couche active (4) disposée sur la première électrode (21) ; et
en utilisant la grille structurée (71) comme plaque-masque pour métalliser la couche active exposée (4) afin de former une deuxième électrode (5), une première partie de contact d'électrode (42) et une première électrode de commande tactile (14) qui sont reliées à la couche active (4), la première partie de contact d'électrode (42) étant reliée à la première électrode (21) par le premier trou de connexion (31).
